# EUROPÄISCHE PATENTSCHRIFT

(11) **EP 2 454 763 B1**
(45) Veröffentlichungstag und Bekanntmachung des Hinweises auf die Patenterteilung: **18.01.2017**
(21) Anmeldenummer: 10724846.0
(22) Anmeldetag: 10.06.2010
(51) Int. Cl.: H01L 33/44, H01L 23/00, H01L 33/40, H01L 33/00

(54) **OPTOELEKTRONISCHES HALBLEITERBAUTEIL UND VERFAHREN ZUR HERSTELLUNG EINES ANORGANISCHEN OPTOELEKTRONISCHEN HALBLEITERBAUTEILS**
OPTOELECTRONIC SEMICONDUCTOR COMPONENT AND METHOD FOR PRODUCING AN INORGANIC OPTOELECTRONIC SEMICONDUCTOR COMPONENT
COMPOSANT SEMICONDUCTEUR OPTOÉLECTRONIQUE ET PROCÉDÉ DE FABRICATION D'UN COMPOSANT SEMICONDUCTEUR OPTOÉLECTRONIQUE INORGANIQUE

(30) Priorität: 17.07.2009 DE 102009033686
(43) Veröffentlichungstag der Anmeldung: 23.05.2012
(73) Patentinhaber: OSRAM Opto Semiconductors GmbH, 93055 Regensburg (DE)
(72) Erfinder: HÖPPEL, Lutz, 93087 Alteglofsheim (DE); VON MALM, Norwin, 93152 Nittendorf - Thumhausen (DE)
(74) Vertreter: Epping - Hermann - Fischer
(86) Internationale Anmeldenummer: PCT/EP2010/058160
(87) Internationale Veröffentlichungsnummer: WO 2011/006719

(56) Entgegenhaltungen:
- EP-A1- 2 063 468
- WO-A1-2009/084670
- WO-A2-2008/045886
- WO-A2-2009/045082
- DE-A1-102007 029 370
- US-A1- 2004 169 181
- US-A1- 2005 211 993
- US-A1- 2007 114 552
- US-A1- 2008 113 462

## Beschreibung

Es wird ein optoelektronisches Halbleiterbauteil angegeben. Darüber hinaus wird ein Verfahren zur Herstellung eines anorganischen optoelektronischen Halbleiterbauteils angegeben.

Die Druckschrift WO 2009/045082 A2 betrifft eine Leuchtdiode und ein Herstellungsverfahren hierfür.

In der Druckschrift DE 10 2007 029 370 A1 sind ein Halbleiterchip und ein Herstellungsverfahren hierfür angegeben.

Ein Schutz epitaktisch erzeugter Strukturen findet sich in der Druckschrift WO 2008/045886 A2.

Die Druckschrift US 2008/0113462 A1 betrifft eine Herstellungsmethode für ein vertikal emittierendes, Strahlung erzeugendes Halbleiterbauteil.

Aus der Druckschrift WO 2009/084670 A1 sind ein lichtemittierendes Halbleiterbauteil und ein Herstellungsverfahren hierfür bekannt.

Dass für die Herstellung von Schichten in Leuchtdioden Atomlagenabscheidung verwendbar ist, ergibt sich aus der Druckschrift US 2004/0169181 A1.

Eine zu lösende Aufgabe besteht darin, ein optoelektronisches Halbleiterbauteil mit einer hohen Lichtauskoppeleffizienz anzugeben. Eine weitere zu lösende Aufgabe besteht darin, ein Verfahren zur Herstellung eines solchen optoelektronischen Halbleiterbauteils anzugeben.

Diese Aufgabe wird gelöst durch ein Halbleiterbauteil und durch ein Verfahren mit den Merkmalen der unabhängigen Patentansprüche.

Das optoelektronische Halbleiterbauteil beinhaltet mindestens eine Halbleiterschichtenfolge. Bei der bevorzugt anorganischen Halbleiterschichtenfolge kann es sich um eine Leuchtdiode, um eine Laserdiode oder um eine Fotodiode handeln. Bevorzugt ist die Halbleiterschichtenfolge eine Dünnfilmschichtenfolge, wie beispielsweise in der Druckschrift DE 10 2007 004 304 A1 angegeben. Die Halbleiterschichtenfolge beinhaltet eine oder mehrere aktive Schichten. Aktiv bedeutet, dass die entsprechende Schicht dazu eingerichtet ist, eine elektromagnetische Strahlung zu emittieren oder zu absorbieren.

Das optoelektronische Halbleiterbauteil umfasst einen Träger. Der Träger ist bevorzugt dazu eingerichtet, die Halbleiterschichtenfolge zu tragen und mechanisch zu stützen. Bei dem Träger handelt es sich insbesondere um einen rigiden, im Rahmen der im verwendungsgemäßen Betrieb des Halbleiterbauteils auftretenden Belastungen biegestabilen Festkörper. Beispielsweise umfasst oder besteht der Träger aus einem Halbleitermaterial wie Germanium oder Silizium, aus einem Metall wie Cu, Ni, Ag oder Mo oder aus einem elektrisch isolierenden Material wie Al₂O₃, AlN oder SiNₓ. Der Träger kann von einem Aufwachssubstrat der Halbleiterschichtenfolge verschieden sein.

Es ist die Halbleiterschichtenfolge an dem Träger angebracht. Das kann bedeuten, dass sich zwischen der Halbleiterschichtenfolge und dem Träger eine oder mehrere Schichten befinden, über die eine Haftvermittlung und eine feste Verbindung zwischen der Halbleiterschichtenfolge und dem Träger gewährleistet ist. Insbesondere besteht kein unmittelbarer Kontakt zwischen einem Material des Trägers und der Halbleiterschichtenfolge.

Das optoelektronische Halbleiterbauteil umfasst einen Metallspiegel. Der Metallspiegel befindet sich zwischen dem Träger und der Halbleiterschichtenfolge. Es ist der gesamte Metallspiegel so angeordnet, dass er sich vollständig zwischen der Halbleiterschichtenfolge und dem Träger befindet. Der Metallspiegel ist dazu eingerichtet, eine von der aktiven Schicht zu emittierende oder zu empfangende Strahlung zu reflektieren. Metallspiegel bedeutet, dass der Spiegel überwiegend oder vollständig aus einem Metall oder einer Metalllegierung besteht. Beispielsweise ist der Metallspiegel ein Silberspiegel. Eine elektrische Verbindung zwischen dem Träger und der Halbleiterschichtenfolge kann über den bevorzugt elektrisch leitfähigen Metallspiegel erfolgen. Der Metallspiegel kann in unmittelbarem Kontakt zu der Halbleiteschichtenfolge stehen.

Insbesondere umfasst oder besteht der Metallspiegel aus einem Material, wie zum Beispiel Silber, das unter dem Einfluss von Sauerstoff oder von Wasser chemisch beschädigt wird. Auch kann ein Material des Metallspiegels, zum Beispiel ebenfalls Silber, zu einer Migration neigen, speziell unter dem Einfluss von Feuchtigkeit und/oder elektrischer Spannung.

Es überragen der Träger und die Halbleiterschichtenfolge den Metallspiegel in einer lateralen Richtung. Die laterale Richtung ist zum Beispiel eine Richtung, die sich parallel entlang einer Haupterstreckungsrichtung des Trägers erstreckt. Insbesondere ist der Metallspiegel in jeder lateralen Richtung sowohl von dem Träger als auch von der Halbleiterschichtenfolge überragt. Mit anderen Worten stehen sowohl der Träger als auch die Halbleiterschichtenfolge in lateraler Richtung bevorzugt ringsum beziehungsweise allseitig über den Metallspiegel über.

Es ist der Metallspiegel in lateraler Richtung unmittelbar von einer für eine von der Halbleiterschichtenfolge zu emittierende oder zu empfangende Strahlung durchlässigen und elektrisch isolierenden oder elektrisch leitfähigen Verkapselungsschicht umgeben. Mit anderen Worten grenzt ein Material der Verkapselungsschicht insbesondere ringsum direkt an ein Material des Metallspiegels, zum Beispiel an alle Begrenzungsflächen des Metallspiegels, die nicht dem Träger oder der Halbleiterschichtenfolge zugewandt sind.

Das optoelektronische Halbleiterbauteil beinhaltet einen Träger und mindestens eine Halbleiterschichtenfolge. Die Halbleiterschichtenfolge weist zumindest eine aktive Schicht auf. Die Halbleiterschichtenfolge ist ferner an dem Träger angebracht. Weiterhin beinhaltet das Halbleiterbauteil einen Metallspiegel, der sich zwischen dem Träger und der Halbleiterschichtenfolge befindet. Der Träger und die Halbleiterschichtenfolge überragen den Metallspiegel in lateraler Richtung. Außerdem ist der Metallspiegel in lateraler Richtung unmittelbar von einer strahlungsdurchlässigen und elektrisch isolierenden oder elektrisch leitfähigen Verkapselungsschicht umgeben.

Dadurch, dass der Metallspiegel in lateraler Richtung von der Verkapselungsschicht insbesondere vollständig umgeben ist, so dass keine der Halbleiterschichtenfolge oder dem Träger zugewandte Begrenzungsfläche des Metallspiegels frei liegt, ist der Metallspiegel vor einer Beschädigung, beispielsweise durch Oxidation, schützbar. Auch kann eine Migration von Bestandteilen des Metallspiegels, zum Beispiel auf laterale Begrenzungsflächen der Halbleiterschichtenfolge, durch die Verkapselungsschicht verhindert oder stark reduziert werden. Durch die Verwendung einer strahlungsdurchlässigen Verkapselungsschicht ist eine Auskoppeleffizienz einer im Halbleiterbauteil beispielsweise erzeugten Strahlung steigerbar, da durch die Verkapselungsschicht im Wesentlichen keine Strahlung absorbiert wird und da insbesondere durch unter der Verkapselungsschicht liegende weitere Schichten eine effiziente Reflexion und Umlenkung der Strahlung erfolgen kann.

Gemäß zumindest einer Ausführungsform des optoelektronischen Halbleiterbauteils weist ein Material der Verkapselungsschicht eine spezifische Diffusionskonstante für Wasser und/oder Sauerstoff von höchstens 10⁻⁵ g/(m² d) auf. Die spezifische Diffusionskonstante ist hierbei insbesondere gerechnet auf eine Materialdicke von 0,1 µm. Bevorzugt beträgt die Diffusionskonstante höchstens 5 x 10⁻⁶ g/(m² d), insbesondere höchstens 10⁻⁶ g/(m² d). Durch ein solches Material für die Verkapselungsschicht ist eine Dicke der Verkapselungsschicht gering wählbar. Weiterhin kann ein solches Material für die Verkapselungsschicht gewährleisten, dass innerhalb einer Lebensdauer der Halbleiterschichtenfolge eine signifikante Korrosion oder chemische Zerstörung des Metallspiegels verhinderbar ist.

Gemäß zumindest einer Ausführungsform des optoelektronischen Halbleiterbauteils umfasst die Verkapselungsschicht oder besteht die Verkapselungsschicht aus einem Siliziumoxid, einem Aluminiumoxid und/oder einem Zirkoniumoxid. Ebenso kann die Verkapselungsschicht eines der folgenden Materialien umfassen oder hieraus bestehen: TiO₂, HfO₂, SnO₂, SiC, Zr(SiO₄), Pb₃(Si₂O₇), Na(AlSiO₄), Si₃N₄, AlN, GaN. Auch andere transparente, feuchtestabile Oxide, Carbide und/oder Nitride können für die Verkapselungsschicht Verwendung finden.

Gemäß zumindest einer Ausführungsform des optoelektronischen Halbleiterbauteils weist der Metallspiegel eine Dicke zwischen einschließlich 100 nm und 200 nm auf, insbesondere zwischen einschließlich 100 nm und 150 nm.

Es liegt eine Dicke der Verkapselungsschicht zwischen einschließlich 20 nm und 100 nm, insbesondere zwischen einschließlich 35 nm und 70 nm. Die Dicke der Verkapselungsschicht ist hierbei insbesondere zu messen in einer Richtung parallel zu einer Wachstumsrichtung der Verkapselungsschicht. Weist die Verkapselungsschicht mehrere, zusammengewachsene Teilbereiche auf, so ist die Dicke insbesondere jeweils für die einzelnen Teilbereiche zu bestimmen, zum Beispiel bis hin zu einer Naht, an der die einzelnen Teilbereiche aneinander grenzen.

Das optoelektronische Halbleiterbauteil umfasst eine zweite Spiegelschicht, die sich zwischen dem Metallspiegel und dem Träger befindet. Die zweite Spiegelschicht grenzt hierbei bevorzugt unmittelbar an den Metallspiegel, so dass ein Material der zweiten Spiegelschicht in physischem Kontakt mit einem Material des Metallspiegels steht. Die zweite Spiegelschicht ist elektrisch leitend und beispielsweise ebenfalls aus zumindest einem Metall geformt. Ein Material der zweiten Spiegelschicht ist beispielsweise Cr oder eine Cr-Legierung. Weitere mögliche Materialien für die zweite Spiegelschicht sind Ti, Ti₃N₄, TiW, TiW(N), Au, Pt, Pd und/oder Ni. Bevorzugt neigt das Material der zweiten Spiegelschicht nicht oder zumindest weniger stark als das Material der Verkapselungsschicht zu Migration und Korrosion unter dem Einfluss von Feuchtigkeit und/oder Sauerstoff.

Es überragt die zweite Spiegelschicht den Metallspiegel in lateraler Richtung ringsum. Ebenso bevorzugt überragt die zweite Spiegelschicht die Verkapselungsschicht in lateraler Richtung, insbesondere ringsum.

Die zweite Spiegelschicht ist dazu eingerichtet, eine durch die Verkapselungsschicht transmittierte, in der aktiven Schicht erzeugte elektromagnetische Strahlung zu reflektieren. Mit anderen Worten wird die auf die Verkapselungsschicht treffende Strahlung mindestens teilweise speziell durch die Verkapselungsschicht transmittiert, von der zweiten Spiegelschicht reflektiert und zum Beispiel hin zu einer Strahlungsdurchtrittsfläche der Halbleiterschichtenfolge gelenkt. Die Strahlungsdurchtrittsfläche ist eine dem Träger abgewandte Begrenzungsfläche der Halbleiterschichtenfolge.

Gemäß zumindest einer Ausführungsform des optoelektronischen Halbleiterbauteils emittiert dieses einen überwiegenden Teil der Strahlung, zum Beispiel mehr als 50 % oder mehr als 80 %, an der dem Träger abgewandten Strahlungsdurchtrittsfläche. Mit anderen Worten kann eine Hauptabstrahlungsrichtung der in dem Halbleiterbauteil erzeugten Strahlung senkrecht zu einer durch Hauptserstreckungsrichtungen der aktiven Schicht aufgespannten Ebene, also insbesondere senkrecht zu einer Seite des Trägersubstrats, auf das die Halbleiterschichtenfolge aufgebracht ist, oder parallel zu einer Wachstumsrichtung der Halbleiterschichtenfolge, orientiert sein.

Es ist die Verkapselungsschicht im Querschnitt U-förmig geformt. Schenkel des U's weisen weg von dem Metallspiegel, das heißt, eine offene Seite des U's ist dem Metallspiegel abgewandt. Mit anderen Worten ist durch die Verkapselungsschicht, insbesondere in dem Bereich, in dem die Halbleiterschichtenfolge und der Träger den Metallspiegel lateral überragen, eine Art Hohlkehle gebildet. Das heißt, die Verkapselungsschicht schmiegt sich an die über den Metallspiegel überstehenden Bereiche der Halbleiterschichtenfolge und des Trägers oder der zweiten Spiegelschicht oder einer Lotverbindungsschicht sowie an die lateralen Begrenzungsflächen des Metallspiegels an, wobei in dem Überstandbereich ein Hohlraum in Richtungen senkrecht zur lateralen Richtung von der Verkapselungsschicht begrenzt ist.

Gemäß zumindest einer Ausführungsform des optoelektronischen Halbleiterbauteils umfasst die Verkapselungsschicht eine Folge von Einzelschichten, wobei mindestens zwei der Einzelschichten ein voneinander verschiedenes Material beinhalten. Beispielsweise weist die Verkapselungsschicht eine alternierende Folge von Einzelschichten von zumindest zwei verschiedenen Materialien auf. Bevorzugt umfasst die Verkapselungsschicht mindestens vier Einzelschichten, bevorzugt mindestens acht Einzelschichten, insbesondere mindestens zwölf Einzelschichten.

Gemäß zumindest einer Ausführungsform des optoelektronischen Halbleiterbauteils beträgt eine Dicke der Einzelschichten jeweils zwischen einschließlich 2 nm und 8 nm, insbesondere zwischen einschließlich 3 nm und 6 nm.

Gemäß zumindest einer Ausführungsform des optoelektronischen Halbleiterbauteils beträgt ein lateraler Überstand der Halbleiterschichtenfolge über den Metallspiegel zwischen einschließlich 50 nm und 2,0 µm. Bevorzugt liegt der laterale Überstand zwischen einschließlich 100 nm und 1,0 µm, insbesondere zwischen einschließlich 100 nm und 500 nm.

Gemäß zumindest einer Ausführungsform des optoelektronischen Halbleiterbauteils ist die Verkapselungsschicht transparent. Eine die Verkapselungsschicht durchlaufende sichtbare Strahlung wird insbesondere zu höchstens 3,0 % absorbiert, bevorzugt zu höchstens 2,0 %. Mit anderen Worten weist die Verkapselungsschicht eine hohe Transparenz auf. Dies ist bevorzugt für solche Spektralbereiche der Fall, in denen von der Halbleiterschichtenfolge im Betrieb des Halbleiterbauteils eine elektromagnetische Strahlung erzeugt wird.

Gemäß zumindest einer Ausführungsform des optoelektronischen Halbleiterbauteils beträgt ein Verhältnis aus einer Fläche des Metallspiegels und einer Fläche der Halbleiterschichtenfolge, gesehen in Draufsicht auf das Halbleiterbauteil, mindestens 95 %, bevorzugt mindestens 97 %, insbesondere mindestens 98,5 %. Mit anderen Worten ist im Wesentlichen die gesamte, dem Träger zugewandte Seite der Halbleiterschichtenfolge von dem Metallspiegel bedeckt.

Gemäß zumindest einer Ausführungsform des optoelektronischen Halbleiterbauteils ist die Strahlungsdurchtrittsfläche der Halbleiterschichtenfolge frei von der Verkapselungsschicht.

Gemäß zumindest einer Ausführungsform des optoelektronischen Halbleiterbauteils ist die Strahlungsdurchtrittsfläche der Halbleiterschichtenfolge von der Verkapselungsschicht bedeckt. Zum Beispiel ist die Strahlungsdurchtrittsfläche von der Verkapselungsschicht, alleine oder zusammen mit einer elektrischen Kontaktstelle an der Strahlungsdurchtrittsfläche, vollständig bedeckt. Ein Material der Verkapselungsschicht ist dann bevorzugt SiO₂.

Gemäß zumindest einer Ausführungsform des optoelektronischen Halbleiterbauteils bedeckt die Verkapselungsschicht alle lateralen Begrenzungsflächen des Metallspiegels, eine dem Träger zugewandte, den Metallspiegel überragende Begrenzungsfläche der Halbleiterschichtenfolge, Flanken der Halbleiterschichtenfolge sowie eine der Halbleiterschichtenfolge zugewandte und von dieser in Draufsicht auf die Strahlungsdurchtrittsfläche überdeckte Begrenzungsfläche des Trägers, der zweiten Spiegelschicht und/oder einer Lotverbindungsschicht teilweise oder, bevorzugt, vollständig.

Es wird darüber hinaus ein Verfahren zur Herstellung eines anorganischen optoelektronischen Halbleiterbauteils angegeben. Es ist mittels des Verfahrens ein Halbleiterbauteil hergestellt, wie in Verbindung mit einer oder mehrerer der oben genannten Ausführungsformen beschrieben. Merkmale des optoelektronischen Halbleiterbauteils sind daher auch für das hier beschriebene Verfahren offenbart und umgekehrt.

Das Verfahren zur Herstellung des anorganischen optoelektronischen Halbleiterbauteils umfasst die Schritte:
- Bereitstellen eines Trägers, einer Halbleiterschichtenfolge und eines Metallspiegels, wobei sich der Metallspiegel zwischen dem Träger und der Halbleiterschichtenfolge befindet und von diesen in lateraler Richtung überragt wird,
- Aufbringen einer strahlungsdurchlässigen, elektrisch isolierenden oder elektrisch leitfähigen Verkapselungsschicht in lateraler Richtung unmittelbar an dem Metallspiegel, wobei die Verkapselungsschicht über eine Atomlagenabscheidung erzeugt wird, und
- Fertigstellen des optoelektronischen Halbleiterbauteils.

Die Halbleiterschichtenfolge wird beispielsweise durch ein epitaktisches Wachsen auf einem Aufwachssubstrat erzeugt. Der Träger ist bevorzugt von dem Aufwachssubstrat verschieden.

Die Verkapselungsschicht kann über eine Atomlagenabscheidung analog zu der in der Druckschrift US 4,058,430 A angegeben erzeugt werden.

Dadurch, dass die Verkapselungsschicht über eine Atomlagenabscheidung, englisch Atomic Layer Deposition oder kurz ALD, erzeugt wird, lässt sich eine besonders gleichmäßig gestaltete, nur vergleichsweise wenige Verunreinigungen und Defekte aufweisende und daher besonders diffusionsbeständige Schicht erzeugen.

Gemäß zumindest einer Ausführungsform des Verfahrens wird auf die Verkapselungsschicht vollständig oder stellenweise eine Schutzschicht über eine Gasphasenabscheidung aufgebracht, insbesondere auf solche Begrenzungsflächen der Verkapselungsschicht, die nicht an den Träger, die Halbleiterschichtenfolge, die zweite Spiegelschicht und/oder eine Lotverbindungsschicht grenzen. Bei der Gasphasenabscheidung kann es sich um eine so genannte Chemical Vapour Deposition, kurz CVD, oder um eine Physical Vapour Deposition, kurz PVD, handeln.

Gemäß zumindest einer Ausführungsform des Verfahrens wird die Schutzschicht mit einer Dicke zwischen einschließlich 100 nm und 500 nm erzeugt. Durch die Schutzschicht ist ein Schutz der Verkapselungsschicht insbesondere gegenüber mechanischen Belastungen und Beschädigungen erreichbar oder auch gegenüber Chemikalien, die reaktiv gegenüber einem Material der Verkapselungsschicht sind.

Gemäß zumindest einer Ausführungsform des Verfahrens erfolgt ein Strukturieren der Halbleiterschichtenfolge und des Metallspiegels mittels derselben Maske und insbesondere mittels eines Ätzens. Auf die Halbleiterschichtenfolge wird eine Maske über beispielsweise ein fotolithographisches Verfahren aufgebracht. Nachfolgend werden Flanken der Halbleiterschichtenfolge, also laterale Begrenzungsflächen der Halbleiterschichtenfolge, erzeugt. Ohne die Maske zu entfernen wird in einem nachfolgenden, insbesondere von einem ersten Ätzschritt verschiedenen zweiten Ätzschritt dann der Metallspiegel strukturiert, wobei ein Überstand der Halbleiterschichtenfolge in einer lateralen Richtung über den Metallspiegel erzielbar und einstellbar ist. Dadurch, dass beide Strukturierungsprozesse mit derselben Maske erfolgen, ist eine hohe Einstellgenauigkeit bezüglich der Formgebung der Halbleiterschichtenfolge relativ zu der Formgebung des Metallspiegels gewährleistet.

Nachfolgend wird ein hier beschriebenes optoelektronisches Halbleiterbauteil sowie ein hier beschriebenes Verfahren unter Bezugnahme auf die Zeichnung näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:

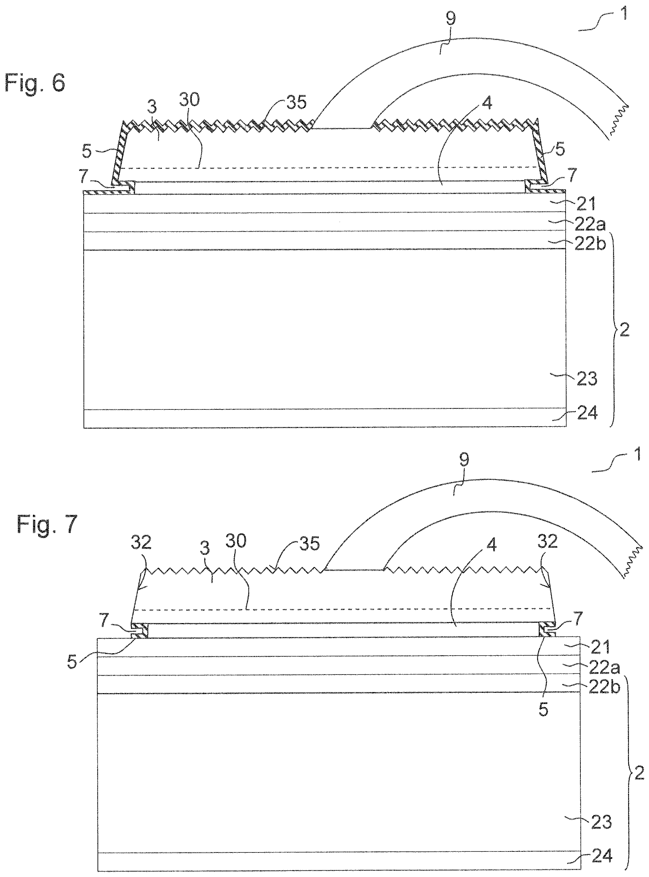

- Figur 6: eine schematische Schnittdarstellung eines Ausführungsbeispiels eines hier beschriebenen optoelektronischen Halbleiterbauteils, und

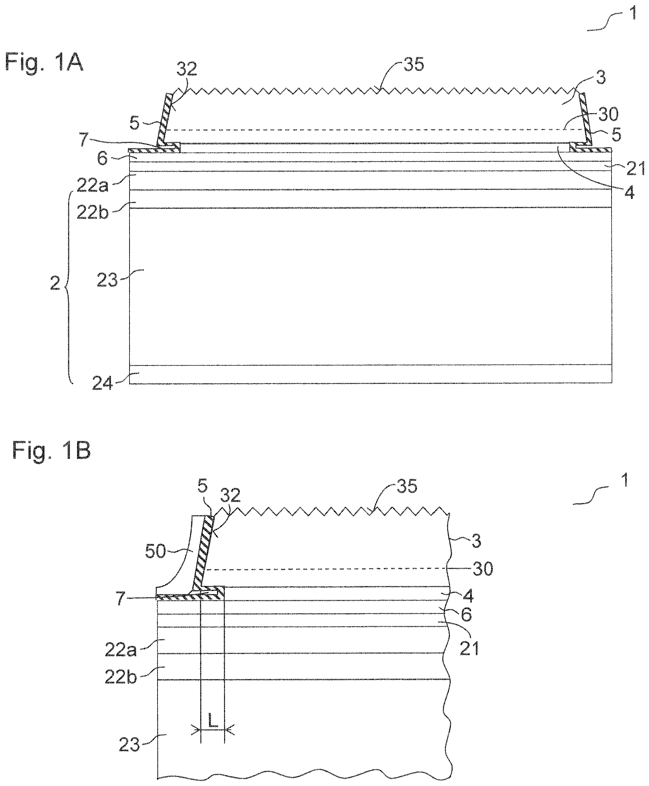

- Figuren 1A, 1B, 2, 3, 4, 5 und 7: schematische Schnittdarstellungen von nicht erfindungsgemäßen Abwandlungen von optoelektronischen Halbleiterbauteilen.

In Figur 1A ist eine nicht erfindungsgemäße Abwandlung eines optoelektronischen Halbleiterbauteils 1 als Schnittdarstellung illustriert. Das Halbleiterbauteil 1 umfasst eine Halbleiterschichtenfolge 3 mit einer aktiven Schicht 30. Eine Strahlungsdurchtrittsfläche 35 der Halbleiterschichtenfolge 3 zeigt eine Aufrauung zur Verbesserung einer Lichtauskopplung aus der Halbleiterschichtenfolge 3 heraus auf.

Beispielsweise ist die aktive Schicht 30 der Halbleiterschichtenfolge 3 dazu eingerichtet, im Betrieb des Halbleiterbauteils 1 eine ultraviolette, eine nahinfrarote oder eine sichtbare Strahlung, insbesondere blaues Licht, zu emittieren. Die Halbleiterschichtenfolge 3 kann auf GaN, InGaN, AlGaN, GaP, InGaAlP, InGaAs oder GaAs basieren.

An einer der Strahlungsdurchtrittsfläche 35 abgewandten Seite der Halbleiterschichtenfolge 3 befindet sich ein Metallspiegel 4. Der Metallspiegel 4 ist zum Beispiel ein Silberspiegel und steht in unmittelbarem Kontakt mit der Halbleiterschichtenfolge 3.

Ferner umfasst das Halbleiterbauteil 1 einen Träger 2. Der Träger 2 beinhaltet ein Trägersubstrat 23, das beispielsweise aus einem Metall, einer Keramik oder aus Silizium oder Germanium gefertigt ist. In einer Richtung hin zu der Halbleiterschichtenfolge 3 grenzen an das Trägersubstrat 23 Lotverbindungsschichten 22a, 22b. Mindestens eine der Lotverbindungsschichten 22a, 22b ist von dem Träger 2 umfasst und auf das Trägersubstrat 23 aufgebracht. Insbesondere die Lotverbindungsschicht 22a kann an der Halbleiterschichtenfolge 3 erzeugt und/oder aufgebracht sein. An einer der Halbleiterschichtenfolge 3 abgewandten Seite des Trägersubstrats 23 befindet sich ferner eine Metallschicht 24. Über die Metallschicht 24 ist das Halbleiterbauteil 1 beispielsweise über eine Oberflächenmontage an einen externen, nicht gezeichneten Montageträger lötbar.

Zwischen der Lotverbindungsschicht 22a und der Halbleiterschichtenfolge 3 befindet sich weiterhin eine Kapselungszwischenschicht 21. Über die Kapselungszwischenschicht 21 ist eine Migration von Bestandteilen zum Beispiel der Lotverbindungsschichten 22a, 22b in die Halbleiterschichtenfolge 3 hinein unterbindbar. Beispielsweise umfasst die Kapselungszwischenschicht 21 TiWN oder besteht hieraus. Zwischen dem Metallspiegel 4 und der Kapselungszwischenschicht 21 befindet sich ferner eine zweite Spiegelschicht 6, die elektrisch leitend und beispielsweise aus Chrom gebildet ist.

Sowohl der Träger 2 als auch die Halbleiterschichtenfolge 3 überragen in einer lateralen Richtung, bevorzugt ringsum, den Metallspiegel 4. Mit anderen Worten stehen die Halbleiterschichtenfolge 3 und der Träger 2 seitlich über den Metallspiegel 4 über. An lateralen Begrenzungsflächen des Metallspiegels 4, an einer der Halbleiterschichtenfolge 3 zugewandten Oberseite der zweiten Spiegelschicht 6, die nicht von dem Metallspiegel 4 bedeckt ist, optional an Flanken 32 der Halbleiterschichtenfolge 3, die laterale Begrenzungsflächen der Halbleiterschichtenfolge 3 darstellen, sowie an einer vom Metallspiegel 4 nicht bedeckten, dem Trägersubstrat 23 zugewandten Unterseite der Halbleiterschichtenfolge 3 befindet sich eine Verkapselungsschicht 5. Die Verkapselungsschicht 5 ist über ein Atomlagenabscheidungsverfahren hergestellt und bevorzugt elektrisch isolierend.

Bevorzugt weist ein Material der Verkapselungsschicht 5 einen geringen Brechungsindex auf, um einen großen Anteil einer Strahlung, die auf die Verkapselungsschicht 5 trifft, über Totalreflexion zu reflektieren. Geringer Brechungsindex kann bedeuten, dass der Brechungsindex oder der mittlere Brechungsindex der Verkapselungsschicht 5 höchstens 1,7, bevorzugt höchstens 1,6 beträgt. Insbesondere ist der mittlere Brechungsindex der Verkapselungsschicht 5 um mindestens 35 % kleiner als ein mittlerer Brechungsindex der Halbleiterschichtenfolge 3.

Die Bestandteile des Halbleiterbauteils können, einzeln oder in Kombination, wie nachfolgend angegeben geformt sein. Eine Dicke der Halbleiterschichtenfolge 3 beträgt bevorzugt zwischen einschließlich 3 µm und 15 µm, insbesondere zwischen einschließlich 4 µm und 6 µm. Der Metallspiegel 4 weist eine Dicke von bevorzugt zwischen einschließlich 100 nm und 150 nm auf. Eine Dicke der Verkapselungsschicht 5 beträgt gemäß Figur 1 weniger als die Hälfte einer Dicke des Metallspiegels 4, so dass durch die Verkapselungsschicht 5 in dem Bereich, in dem die Halbleiterschichtenfolge 3 und der Träger 2 den Metallspiegel 4 lateral überragen, eine Hohlkehle 7 gebildet ist. Die Verkapselungsschicht 5 ist dann bevorzugt zwischen einschließlich 30 nm und 70 nm dick.

Eine Dicke der zweiten Spiegelschicht 6 liegt bevorzugt zwischen einschließlich 50 nm und 250 nm. Eine Dicke der Kapselungszwischenschicht 21 beträgt beispielsweise zwischen einschließlich 200 nm und 1,5 µm. Die Lotverbindungsschichten 22a, 22b weisen, zusammengenommen, zum Beispiel eine Dicke zwischen einschließlich 1 µm und 6 µm auf und sind insbesondere mit Au, Zn, Ni und/oder In gebildet oder bestehen hieraus. Das Trägersubstrat 23 zeigt eine Dicke bevorzugt zwischen einschließlich 50 µm und 500 µm, insbesondere zwischen einschließlich 75 µm und 200 µm auf. Die metallischen Kontaktschichten 24, die beispielsweise aus Au oder einer Au-Legierung bestehen, haben zum Beispiel eine Dicke zwischen einschließlich 50 nm und 300 nm.

Das Halbleiterbauteil 1 kann wie folgt hergestellt werden: Auf einem nicht gezeichneten Aufwachssubstrat wird die Halbleiterschichtenfolge 3 beispielsweise epitaktisch aufgewachsen. Außerdem werden an einer dem Aufwachssubstrat abgewandten Seite der Halbleiterschichtenfolge 3 der Metallspiegel 4 und die zweite Spiegelschicht 6 beispielsweise aufgedruckt, aufgedampft oder über ein galvanisches Verfahren abgeschieden. Ferner wird an der zweiten Spiegelschicht 6 die Kapselungszwischenschicht 21 aufgebracht, an der wiederum die Lotverbindungsschicht 22a erzeugt wird.

Weiterhin wird der Träger 2 mit der Lotverbindungsschicht 22b, dem Trägersubstrat 23 und der metallischen Kontaktschicht 24 bereitgestellt. Vor oder auch nach einem Ablösen der Halbleiterschichtenfolge 3 von dem nicht dargestellten Aufwachssubstrat werden die Lotverbindungsschichten 22a, 22b miteinander verlötet, wodurch der Träger 2 fest mit der Halbleiterschichtenfolge 3 verbunden wird. Ebenso kann der Träger 2 galvanisch an der Halbleiterschichtenfolge 3 aufgebracht sein.

Insbesondere nach dem Entfernen des Aufwachssubstrats von der Halbleiterschichtenfolge 3 wird auf der Halbleiterschichtenfolge 3 eine nicht gezeichnete Maske, beispielsweise in Form eines Fotolacks, aufgebracht. Über zum Beispiel ein Ätzen werden dann die Flanken 32 der Halbleiterschichtenfolge 3 erzeugt und die Halbleiterschichtenfolge 3 in ihren lateralen Ausdehnungen strukturiert. Ohne die nicht gezeichnete Maske zu entfernen, wird mit einem anderen Ätzverfahren bevorzugt anschließend der Metallspiegel 4 strukturiert und dessen laterale Abmessungen bestimmt. Durch diese Strukturierung wird der Überstand der Halbleiterschichtenfolge 3 über den Metallspiegel 4 erzeugt. Eine Strukturierung der Halbleiterschichtenfolge 3 sowie des Metallspiegels 4 erfolgt also bevorzugt über dieselbe Maske in aufeinander folgenden Ätzschritten. Zum Beispiel nach dem Entfernen der nicht dargestellten Maske kann dann die Strukturierung an der Strahlungsdurchtrittsfläche 35 erzeugt werden.

Vor oder auch nach dem Erzeugen der Strukturierung an der Strahlungsdurchtrittsfläche 35 wird die Verkapselungsschicht 5 über eine Atomlagenabscheidung erzeugt. Die Strahlungsdurchtrittsfläche 35 bleibt dabei bevorzugt frei von der Verkapselungsschicht 5. Die Verkapselungsschicht 5 umfasst eine oder mehrere nicht gezeichnete Einzelschichten mit oder aus einem Siliziumdioxid und/oder einem Aluminiumoxid, wobei die Lagen jeweils eine Dicke zwischen bevorzugt einschließlich 2 nm und 8 nm aufweisen und eine Gesamtdicke der Verkapselungsschicht 5 bevorzugt zwischen einschließlich 30 nm und 70 nm beträgt. Beispielsweise sind Einzelschichten aus SiO₂ sowie Al₂O₃ abwechselnd angeordnet.

Ein lateraler Überstand L der Halbleiterschichtenfolge 3 über den Metallspiegel 4 beträgt bevorzugt zwischen einschließlich 100 nm und 5 µm. Bevorzugt ist der laterale Überstand L kleiner als 1 µm oder kleiner als 0,5 µm. Derart kleine Überstände L sind dadurch realisierbar, dass eine Strukturierung der Halbleiterschichtenfolge 3 sowie des Metallspiegels 4 mittels derselben nicht dargestellten Maske erfolgt, so dass die Strukturierungen des Metallspiegels sowie der Halbleiterschichtenfolge 3 relativ zueinander präzise erfolgt.

Ferner ist die Verkapselungsschicht 5 bevorzugt transparent und absorbiert eine zum Beispiel in der Halbleiterschichtenfolge 3 erzeugte elektromagnetische Strahlung nicht oder nur vernachlässigbar. Ist die aktive Schicht zur Erzeugung einer Strahlung eingerichtet, so kann ein Teil der in der aktiven Schicht 30 erzeugten Strahlung die Verkapselungsschicht 5 verlustarm durchlaufen und an der zweiten Spiegelschicht 6 zurück, zum Beispiel in Richtung zur Strahlungsdurchtrittsfläche 35, reflektiert werden. Hierdurch erhöht sich eine Auskoppeleffizienz der Strahlung aus dem Halbleiterbauteil 1.

In Figur 1B ist eine Detailansicht der Verkapselungsschicht 5 dargestellt. Ferner ist gemäß Figur 1B an der Verkapselungsschicht 5 eine Schutzschicht 50 aufgebracht. Eine Dicke der Schutzschicht 50 beträgt beispielsweise zwischen einschließlich 100 nm und 400 nm.

Im Gegensatz zur durch ein Atomlagenabscheiden, kurz ALD, erzeugten Verkapselungsschicht 5 ist die Schutzschicht 50 beispielsweise über CVD oder PVD erstellt. Im Gegensatz zu der ALD, über die die Verkapselungsschicht 5 hergestellt ist, ist eine CVD oder PVD im Regelfall nicht in der Lage, die Hohlkehle 7 mit einem Material vollständig auszufüllen. Hierdurch verbleibt in dem Bereich, in dem die Halbleiterschichtenfolge 3 und der Träger 2 lateral über dem Metallspiegel 4 überstehen, ein Hohlraum zurück, der von der Verkapselungsschicht 5 und der Schutzschicht 50 umschlossen ist.

Ferner unterscheiden sich die durch ALD erstellte Verkapselungsschicht 5 und die über CVD oder PVD erzeugte Schutzschicht 50 dadurch, dass eine Defektdichte bei der ALD-Verkapselungsschicht 5 typisch kleiner als 0,1 Defekte pro Quadratmillimeter beträgt, wohingegen die CVD- oder PVD-Schutzschicht 50 eine Defektdichte von einigen 100 Defekten pro Quadratmillimeter aufweist. Dies ist beispielsweise über Transmissionselektronenmikroskopie, kurz TEM, nachweisbar. Aufgrund der vergleichsweise geringeren Defektdichte der ALD-Verkapselungsschicht 5 ist auch eine Ätzrate, im Vergleich zur CVD- oder PVD-Schutzschicht 50, reduziert. Insbesondere ist dies der Fall, falls die Verkapselungsschicht 5 und die Schutzschicht 50 aus Aluminiumoxid bestehen oder dieses umfassen. Beispielsweise über die Defektdichte und/oder die Ätzrate ist feststellbar, welche der Schichten 5, 50 über welche Methode erzeugt wurde.

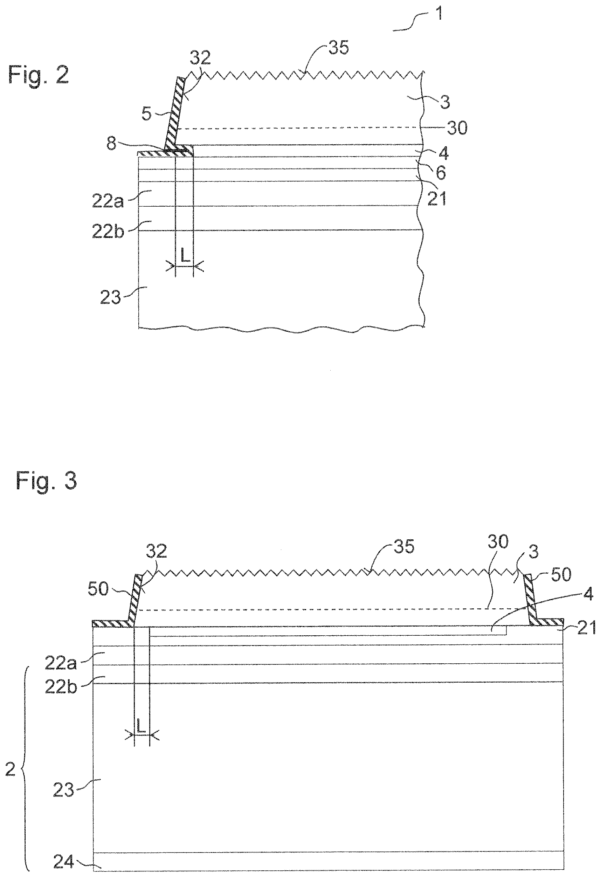

Bei der nicht erfindungsgemäßen Abwandlung gemäß Figur 2 ist die Verkapselungsschicht 5 derart dick über ALD gewachsen, so dass sich eine von der Halbleiterschichtenfolge 3 her gewachsene Teilschicht und eine von der zweiten Spiegelschicht 6 her gewachsene Teilschicht der Verkapselungsschicht 5 berühren und eine Naht 8 ausbilden. Hierdurch ist eine besonders effiziente Verkapselung des Metallspiegels 4 gegenüber Sauerstoff und/oder Wasser gewährleistet.

In Figur 3 ist eine Schnittdarstellung einer nicht erfindungsgemäßen Abwandlung eines Halbleiterbauteils illustriert. Bei diesem herkömmlichen Aufbau ist der Metallspiegel 4 auch in lateraler Richtung von der Kapselungszwischenschicht 21 umgeben. Besteht die Kapselungszwischenschicht 21 zum Beispiel aus TiWN, das eine schwarze oder bräunliche Färbung aufzeigt, so wird etwa in der Halbleiterschichtenfolge 3 erzeugte Strahlung an der Kapselungszwischenschicht 21 stark absorbiert und nicht aus dem Halbleiterbauteil ausgekoppelt. Liegt eine laterale Ausdehnung der Halbleiterschichtenfolge 3 im Bereich von einigen hundert Mikrometern und der laterale Überstand L im Bereich von einigen Mikrometern, so wird durch die Kapselungszwischenschicht 21 ein Strahlungsanteil einer in der aktiven Schicht 30 erzeugten Strahlung in der Größenordnung mehrerer Prozent absorbiert. Näherungsweise um diesen Strahlungsanteil ist eine Effizienz eines Halbleiterbauteils 1, etwa gemäß Figur 1 oder 2, gegenüber dem Bauteil gemäß Figur 3 steigerbar.

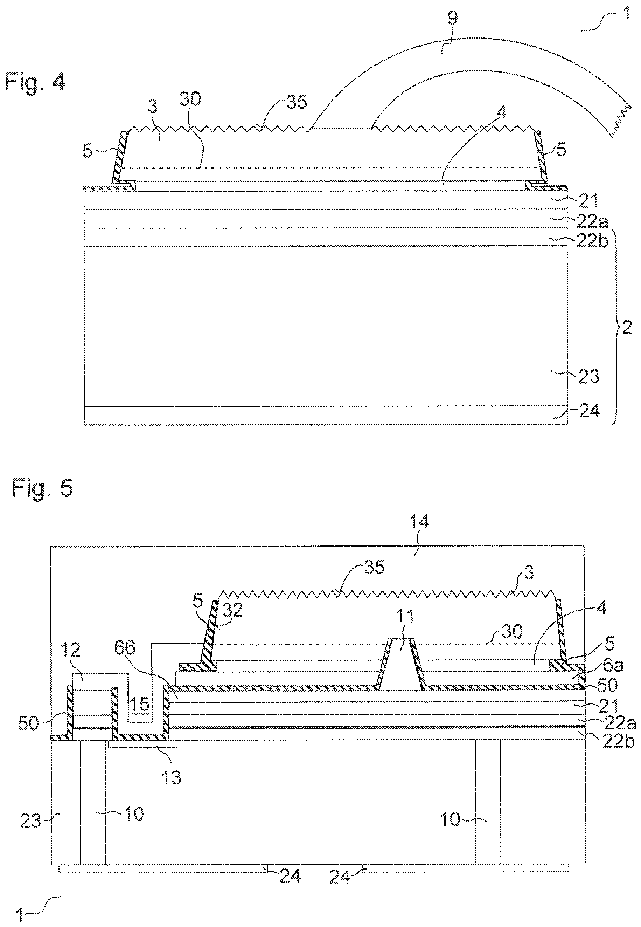

Gemäß der nicht erfindungsgemäßen Abwandlung nach Figur 4 ist an der Strahlungsdurchtrittsfläche 35 ein Bonddraht 9 angebracht. Eine Bestromung des Halbleiterbauteils 1 erfolgt dann also über die metallische Kontaktschicht 24 und über den Bonddraht 9.

Bei der nicht erfindungsgemäßen Abwandlung gemäß Figur 5 umfasst das Halbleiterbauteil 1 zwei metallische Kontaktschichten 24, die jeweils über elektrische Durchkontaktierungen 10 zu einer der Halbleiterschichtenfolge 3 zugewandten Seite des Trägersubstrats 23 geführt sind. Eine elektrische Kontaktierung einer dem Trägersubstrat 23 zugewandten Seite der Halbleiterschichtenfolge 3 erfolgt ferner über die elektrische Brücke 12, die eine Ausnehmung 15 in den Lotverbindungsschichten 22a, 22b und in der Kapselungszwischenschicht 21 überbrückt. Eine dem Trägersubstrat 23 abgewandte Seite der Halbleiterschichtenfolge wird über einen Durchbruch 11, der zum Beispiel mit Kupfer gefüllt ist, elektrisch angeschlossen. Die Verkapselungsschicht 5 ist beispielsweise wie in den Figuren 1B oder 2 dargestellt ausgeführt.

Wie auch bei allen anderen Beispielen kann die Halbleiterschichtenfolge 3 von einem Verguss 14 umgeben sein. Dem Verguss 14 kann mindestens ein Konversionsmittel, mindestens ein Diffusionsmittel und/oder mindestens ein Filtermittel beigegeben sein. Dem Trägersubstrat 23 kann optional, wie auch bei den anderen Beispielen, ein elektrisches Funktionselement 13 integriert sein, das beispielsweise als Schutzvorrichtung vor elektrostatischer Entladung ausgeführt ist.

Gemäß dem Ausführungsbeispiel in Figur 6 bedeckt die Verkapselungsschicht 5 die Strahlungsdurchtrittsfläche 35, insbesondere mit Ausnahme eines optional vorhandenen Anschlussbereichs für den Bonddraht 9, vollständig oder nahezu vollständig. Die Verkapselungsschicht 5 besteht bei einer derartigen Ausformung aus einem für zumindest einen Teil der in der Halbleiterschichtenfolge 3 erzeugten Strahlung transparenten Material oder beinhaltet ein solches Material. Zum Beispiel weist die Verkapselungsschicht 5 dann Siliziumdioxid auf oder besteht hieraus, wobei das Siliziumdioxid dotiert sein kann. Eine Dotierung erfolgt insbesondere mit Aluminium mit einer Dotierstoffkonzentration von bevorzugt höchstens 1000 ppm oder von höchstens 100 ppm, wobei ppm für parts per million steht.

Bei der nicht erfindungsgemäßen Abwandlung gemäß Figur 7 erstreckt sich die Verkapselungsschicht 5 ausschließlich oder im Wesentlichen auf die Hohlkehle 7. Anders als in Figur 7 dargestellt ist es ebenso möglich, dass sich die Verkapselungsschicht 5 auch zum Teil auf die Flanken 32 der Halbleiterschichtenfolge 3 erstreckt, wobei die Verkapselungsschicht 5 dann jedoch die aktive Schicht 30 nicht erreicht oder, in einer Richtung weg vom Trägersubstrat 23, nicht überschreitet. Ebenso können auch außerhalb der Hohlkehle 7 gelegene Teile der Kapselungszwischenschicht 21 von der Verkapselungsschicht 5 bedeckt sein.

Insbesondere bei einer derartigen Ausformung der Verkapselungsschicht 5 ist es möglich, für die Verkapselungsschicht 5 elektrisch leitfähige Materialien einzusetzen. Zum Beispiel besteht die Verkapselungsschicht 5 aus einem der folgenden Materialien oder weist eines oder mehrere dieser Materialien auf: ein transparentes leitfähiges Oxid wie Indiumzinnoxid, ein reines Metall wie Wolfram.

Eine solche Verkapselungsschicht 5, wie in Figur 7 dargestellt, kann erzeugt werden, indem ein Material für die Verkapselungsschicht 5 erst insbesondere auf die gesamte Halbleiterschichtenfolge 3 aufgebracht wird, ähnlich wie beim Ausführungsbeispiel gemäß Figur 6, und nachfolgend das Material stellenweise entfernt wird.

Die hier beschriebene Erfindung ist nicht durch die Beschreibung anhand der Beispiele beschränkt.
Diese Patentanmeldung beansprucht die Priorität der deutschen Patentanmeldung 10 2009 033 686.9.

## Patentansprüche

1. Optoelektronisches Halbleiterbauteil (1) mit
- einem Träger (2),
- mindestens einer Halbleiterschichtenfolge (3) mit zumindest einer aktiven Schicht (30), wobei die Halbleiterschichtenfolge (3) an dem Träger (2) angebracht ist, und
- einem Metallspiegel (4), der sich vollständig zwischen dem Träger (2) und der Halbleiterschichtenfolge (3) befindet und der dazu eingerichtet ist, eine von der aktiven Schicht emittierte Strahlung zu reflektieren,
wobei
- der Träger (2) und die Halbleiterschichtenfolge (3) den Metallspiegel (4) in lateraler Richtung überragen, und
- der Metallspiegel (4) in lateraler Richtung unmittelbar von einer Verkapselungsschicht (5) umgeben ist,
- die Verkapselungsschicht (5) Flanken (32) der Halbleiterschichtenfolge (3) sowie eine Strahlungsdurchtrittsfläche (35), mit Ausnahme eines optional vorhandenen Anschlussbereichs für einen Bonddraht (9), vollständig bedeckt, und
- die Strahlungsdurchtrittsfläche (35) eine dem Träger (2) abgewandte Begrenzungsfläche der Halbleiterschichtenfolge (3) ist,
- eine metallische zweite Spiegelschicht (6, 21) sich zwischen dem Metallspiegel (4) und dem Träger (2) befindet und den Metallspiegel (4) in lateraler Richtung ringsum überragt,
- die zweite Spiegelschicht (6, 21) dazu eingerichtet ist, eine durch die Verkapselungsschicht (5)transmittierte in der aktiven Schicht erzeugte elektromagnetische Strahlung zu reflektieren,
**dadurch gekennzeichnet, dass**
- die Verkapselungsschicht (5) im Querschnitt U-förmig geformt ist, sodass Schenkel des U's weg von dem Metallspiegel (4) weisen und somit eine offene Seite des U's dem Metallspiegel (4) abgewandt ist,
- eine Dicke der Verkapselungsschicht (5) zwischen einschließlich 20 nm und 100 nm beträgt, und
- auf der Verkapselungsschicht (5) zumindest stellenweise eine Schutzschicht (50) aufgebracht ist.

2. Optoelektronisches Halbleiterbauteil (1) nach dem vorhergehenden Anspruch,
bei dem eine Dicke der Verkapselungsschicht (5) zwischen einschließlich 30 nm und 70 nm und eine Defektdichte der Verkapselungsschicht (5) höchstens 0,1 Defekte pro Quadratmillimeter beträgt und die Verkapselungsschicht (5) durch Atomlagenabscheidungsverfahren erzeugt ist,
wobei die Verkapselungsschicht (5) elektrisch isolierend sowie strahlungsdurchlässig ist.

3. Optoelektronisches Halbleiterbauteil (1) nach einem der vorhergehenden Ansprüche,
bei dem die Verkapselungsschicht (5) eines der Materialien Indiumzinnoxid, Wolfram, SiO₂, Al₂O₃ und/oder ZrO₂ umfasst.

4. Optoelektronisches Halbleiterbauteil (1) nach einem der vorhergehenden Ansprüche,
bei dem ein Material der Verkapselungsschicht (5) eine spezifische Diffusionskonstante für Wasser und Sauerstoff von höchstens 10⁻⁵ g/(m² d), gerechnet auf eine Materialdicke von 0,1 µm, aufweist, und
die Verkapselungsschicht (5) durch Atomlagenabscheidungsverfahren erzeugt ist.

5. Optoelektronisches Halbleiterbauteil (1) nach einem der vorhergehenden Ansprüche,
bei dem der Metallspiegel (4) eine Dicke zwischen einschließlich 100 nm und 200 nm aufweist,
wobei ist die Verkapselungsschicht (5) derart dick gewachsen ist, so dass sich eine von der Halbleiterschichtenfolge (3) her gewachsene Teilschicht und eine von der zweiten Spiegelschicht (6) her gewachsene Teilschicht der Verkapselungsschicht (5) berühren und eine Naht (8) ausbilden.

6. Optoelektronisches Halbleiterbauteil (1) nach einem der Ansprüche 1 bis 4,
bei dem in dem Bereich, in dem die Halbleiterschichtenfolge (3) und der Träger (2) den Metallspiegel (4) lateral überragen, eine Hohlkehle gebildet ist.

7. Optoelektronisches Halbleiterbauteil (1) nach einem der vorhergehenden Ansprüche,
bei dem die Verkapselungsschicht (5) eine Folge von Einzelschichten (5a, 5b) mindestens zweier verschiedener Materialien umfasst, wobei die Verkapselungsschicht (5) insgesamt mindestens vier Einzelschichten (5a, 5b) umfasst und eine Dicke der Einzelschichten (5a, 5b) jeweils zwischen einschließlich 2 nm und 8 nm beträgt.

8. Optoelektronisches Halbleiterbauteil (1) nach einem der vorhergehenden Ansprüche,
bei dem ein lateraler Überstand (L) der Halbleiterschichtenfolge (3) über den Metallspiegel (4) zwischen einschließlich 100 nm und 2,0 µm beträgt.

9. Optoelektronisches Halbleiterbauteil (1) nach einem der vorhergehenden Ansprüche,
bei dem die Verkapselungsschicht (5) klarsichtig ist und eine durchlaufende, von der aktiven Schicht (30) erzeugte oder zu empfangende Strahlung zu höchstens 3,0 % absorbiert,
wobei die Verkapselungsschicht (5) Siliziumdioxid aufweist und eine Dotierung mit Aluminium erfolgt mit einer Dotierstoffkonzentration von höchstens 1000 ppm.

10. Optoelektronisches Halbleiterbauteil (1) nach einem der vorhergehenden Ansprüche,
wobei die zweite Spiegelschicht (6) die Verkapselungsschicht (5) in lateraler Richtung ringsum überragt.

11. Optoelektronisches Halbleiterbauteil (1) nach einem der vorhergehenden Ansprüche,
bei dem der Metallspiegel (4) ein Silberspiegel ist, wobei die zweite Spiegelschicht (6) unmittelbar an den Metallspiegel (4) grenzt, und
wobei die zweite Spiegelschicht (6) elektrisch leitend ist und eines der nachfolgenden Materialien aufweist: Cr, eine Cr-Legierung, Ti, Au, Pt, Pd, Ni.

12. Optoelektronisches Halbleiterbauteil (1) nach einem der vorhergehenden Ansprüche,
bei dem ein Verhältnis aus einer Fläche des Metallspiegels (4) und einer Fläche der Halbleiterschichtenfolge (3) mindestens 95 % beträgt.

13. Verfahren zur Herstellung eines anorganischen optoelektronischen Halbleiterbauteils nach einem der vorhergehenden Ansprüche mit den Schritten:
- Bereitstellen des Trägers (2), der Halbleiterschichtenfolge (3) und des Metallspiegels (4), wobei sich der Metallspiegel (4) zwischen dem Träger (2) und der Halbleiterschichtenfolge (3) befindet und von diesen in lateraler Richtung überragt wird, und nachfolgend
- Aufbringen der Verkapselungsschicht (5) in lateraler Richtung unmittelbar an dem Metallspiegel (4),
wobei der Träger (2) von einem Aufwachssubstrat der Halbleiterschichtenfolge (3) verschieden ist, und wobei die Verkapselungsschicht (5) über eine Atomlagenabscheidung erzeugt wird.

14. Verfahren nach dem vorhergehenden Anspruch,
wobei auf der Verkapselungsschicht (5) über eine Gasphasenabscheidung eine Schutzschicht (50) mit einer Dicke zwischen einschließlich 100 nm und 500 nm aufgebracht wird.

15. Verfahren nach Anspruch 13 oder nach dem vorhergehenden Anspruch,
wobei das Strukturieren der Halbleiterschichtenfolge (4) und des Metallspiegels (4) mittels Ätzen und mittels derselben Maske erfolgt.

## Claims

1. Optoelectronic semiconductor component (1) comprising
- a carrier (2),
- at least one semiconductor layer sequence (3) comprising at least one active layer (30), wherein the semiconductor layer sequence (3) is fitted to the carrier (2) and
- a metal mirror (4), which is situated completely between the carrier (2) and the semiconductor layer sequence (3) and which is designed to reflect a radiation emitted by the active layer,
wherein
- the carrier (2) and the semiconductor layer sequence (3) project beyond the metal mirror (4) in a lateral direction, and
- the metal mirror (4) is surrounded directly by an encapsulation layer (5) in a lateral direction,
- the encapsulation layer (5) completely covers flanks (32) of the semiconductor layer sequence (3) and also a radiation passage surface (35), with the exception of an optionally present connection region for a bonding wire (9), and
- the radiation passage surface (35) is a delimiting surface of the semiconductor layer sequence (3) facing away from the carrier (2),
- a metallic second mirror layer (6, 21) is situated between the metal mirror (4) and the carrier (2) and projects beyond the metal mirror (4) all around in a lateral direction,
- the second mirror layer (6, 21) is designed to reflect an electromagnetic radiation generated in the active layer and transmitted through the encapsulation layer (5),
**characterized in that**
- the encapsulation layer (5) is shaped such that it is U-shaped in cross section, and so lugs of the U point away from the metal mirror (4) and an open side of the U thus faces away from the metal mirror (4),
- a thickness of the encapsulation layer (5) is between 20 nm and 100 nm inclusive,
and
- a protective layer (50) is applied on the encapsulation layer (5) at least in places.

2. Optoelectronic semiconductor component (1) according to the preceding claim,
wherein a thickness of the encapsulation layer (5) is between 30 nm and 70 nm inclusive and a deflect density of the encapsulation layer (5) is at most 0.1 defect per square millimetre, and the encapsulation layer (5) is produced by atomic layer deposition methods, wherein the encapsulation layer (5) is electrically insulating and radiation-transmissive.

3. Optoelectronic semiconductor component (1) according to either of the preceding claims,
wherein the encapsulation layer (5) comprises one of the materials indium tin oxide, tungsten, SiO₂, Al₂O₃ and/or ZrO₂.

4. Optoelectronic semiconductor component (1) according to any of the preceding claims,
wherein a material of the encapsulation layer (5) has a specific diffusion constant for water and oxygen of at least 10⁻⁵ g(/m² d), calculated to a material thickness of 0.1 µm, and the encapsulation layer (5) is produced by atomic layer deposition methods.

5. Optoelectronic semiconductor component (1) according to any of the preceding claims,
wherein the metal mirror (4) has a thickness of between 100 nm and 200 nm inclusive,
wherein the encapsulation layer (5) is grown with a thickness such that a partial layer grown from the semiconductor layer sequence (3) and a partial layer of the encapsulation layer (5) grown from the second mirror layer (6) touch one another and form a seam (8).

6. Optoelectronic semiconductor component (1) according to any of the preceding Claims 1 to 4,
wherein a hollow groove is formed in the region in which the semiconductor layer sequence (3) and the carrier (2) project beyond the metal mirror (4) laterally.

7. Optoelectronic semiconductor component (1) according to any of the preceding claims,
wherein the encapsulation layer (5) comprises a sequence of individual layers (5a, 5b) of at least two different materials, wherein the encapsulation layer (5) overall comprises at least four individual layers (5a, 5b) and a thickness of the individual layers (5a, 5b) is in each case between 2 nm and 8 nm inclusive.

8. Optoelectronic semiconductor component (1) according to any of the preceding claims,
wherein a lateral projection (L) of the semiconductor layer sequence (3) beyond the metal mirror (4) is between 100 nm and 2.0 µm inclusive.

9. Optoelectronic semiconductor component (1) according to any of the preceding claims,
wherein the encapsulation layer (5) is transparent and absorbs at most 3.0% of radiation which passes through and which is generated or is to be received by the active layer (30),
wherein the encapsulation layer (5) comprises silicon dioxide and a doping with aluminium is carried out with a dopant concentration of at most 1000 ppm.

10. Optoelectronic semiconductor component (1) according to any of the preceding claims,
wherein the second mirror layer (6) projects beyond the encapsulation layer (5) all around in a lateral direction.

11. Optoelectronic semiconductor component (1) according to any of the preceding claims,
wherein the metal mirror (4) is a silver mirror, wherein the second mirror layer (6) directly adjoins the metal mirror (4), and
wherein the second mirror layer (6) is electrically conductive and comprises one of the following materials: Cr, a Cr alloy, Ti, Au, Pt, Pd, Ni.

12. Optoelectronic semiconductor component (1) according to any of the preceding claims,
wherein a ratio of an area of the metal mirror (4) and an area of the semiconductor layer sequence (3) is at least 95%.

13. Method for producing an inorganic optoelectronic semiconductor component according to any of the preceding claims comprising the following steps:
- providing the carrier (2), the semiconductor layer sequence (3) and the metal mirror (4), wherein the metal mirror (4) is situated between the carrier (2) and the semiconductor layer sequence (3) and said carrier and said semiconductor layer sequence project beyond said metal mirror in a lateral direction, and subsequently
- applying the encapsulation layer (5) in a lateral direction directly to the metal mirror (4),
wherein the carrier (2) is different from a growth substrate of the semiconductor layer sequence (3), and wherein the encapsulation layer (5) is produced by means of an atomic layer deposition.

14. Method according to the preceding claim,
wherein a protective layer (50) having a thickness of between 100 nm and 500 nm inclusive is applied on the encapsulation layer (5) by means of a vapour deposition.

15. Method according to Claim 13, or according to the preceding claim,
wherein the semiconductor layer sequence (4) and the metal mirror (4) are structured by means of etching and by means of the same mask.

## Revendications

1. Composant semiconducteur optoélectronique (1), comprenant
- un support (2),
- au moins une séquence de couches semiconductrices (3) avec au moins une couche active (30), la séquence de couches semiconductrices (3) étant appliquée sur le support (2), et
- un miroir métallique (4) qui se trouve entièrement entre le support (2) et la séquence de couches semiconductrices (3) et qui est conçu pour réfléchir un rayonnement émis par la couche active,
- le support (2) et la séquence de couches semiconductrices (3) débordant latéralement du miroir métallique (4), et
- le miroir métallique (4) étant entouré directement par une couche d'encapsulation (5) dans le sens latéral,
- la couche d'encapsulation (5) recouvrant entièrement les flans (32) de la séquence de couches semiconductrices (3) ainsi qu'une surface de traversée du rayonnement (35), à l'exception d'une zone de raccordement optionnelle présente pour un fil de connexion (9), et
- la surface de traversée du rayonnement (35) étant une surface de délimitation de la séquence de couches semiconductrices (3) à l'opposé du support (2),
- une deuxième couche de miroir métallique (6, 21) se trouvant entre le miroir métallique (4) et le support (2) et débordant tout autour du miroir métallique (4) dans la direction latérale,
- la deuxième couche de miroir (6, 21) étant conçue pour réfléchir un rayonnement électromagnétique généré dans la couche active et transmis à travers la couche d'encapsulation (5),
**caractérisé en ce que**
- la couche d'encapsulation (5) est réalisée avec une section transversale en forme de U, de sorte que les branches du U sont orientées à l'écart du miroir métallique (4) et un côté ouvert du U est ainsi opposé au miroir métallique (4),
- une épaisseur de la couche d'encapsulation (5) est comprise entre 20 nm et 100 nm inclus, et
- au moins une couche de protection (50) est appliquée à certains endroits sur la couche d'encapsulation (5).

2. Composant semiconducteur optoélectronique (1) selon la revendication précédente, avec lequel une épaisseur de la couche d'encapsulation (5) est comprise entre 30 nm et 70 nm inclus et une densité de défaut de la couche d'encapsulation (5) est au maximum égale à 0,1 défaut par millimètre au carré et la couche d'encapsulation (5) est générée par un procédé de précipitation de couches d'atomes, la couche d'encapsulation (5) étant électriquement isolante ainsi que transparente au rayonnement.

3. Composant semiconducteur optoélectronique (1) selon l'une des revendications précédentes, avec lequel la couche d'encapsulation (5) comprend l'un des matériaux oxyde d'étain-indium, tungstène, SiO₂, Al₂O₃ et/ou ZrO₂.

4. Composant semiconducteur optoélectronique (1) selon l'une des revendications précédentes, avec lequel un matériau de la couche d'encapsulation (5) possède une constante de diffusion spécifique pour l'eau et l'oxygène égale au maximum à 10⁻⁵ g/(m²d), calculée sur une épaisseur de matière de 0,1 µm, et la couche d'encapsulation (5) est générée par un procédé de précipitation de couches d'atomes.

5. Composant semiconducteur optoélectronique (1) selon l'une des revendications précédentes, avec lequel le miroir métallique (4) possède une épaisseur entre 100 nm et 200 nm inclus, la couche d'encapsulation (5) étant mise en croissance jusqu'à une épaisseur telle qu'une couche partielle crûe depuis la séquence de couches semiconductrices (3) et une couche partielle crûe depuis la deuxième couche de miroir (6) de la couche d'encapsulation (5) se touchent et forment une jonction (8).

6. Composant semiconducteur optoélectronique (1) selon l'une des revendications 1 à 4, avec lequel une moulure creuse est formée dans la zone dans laquelle la séquence de couches semiconductrices (3) et le support (2) débordent latéralement du miroir métallique (4).

7. Composant semiconducteur optoélectronique (1) selon l'une des revendications précédentes, avec lequel la couche d'encapsulation (5) comprend une séquence de couches individuelles (5a, 5b) d'au moins deux matériaux différents, la couche d'encapsulation (5) comprenant au total au moins quatre couches individuelles (5a, 5b) et une épaisseur des couches individuelles (5a, 5b) étant respectivement comprise entre 2 nm et 8 nm inclus.

8. Composant semiconducteur optoélectronique (1) selon l'une des revendications précédentes, avec lequel un porte-à-faux latéral (L) de la séquence de couches semiconductrices (3) au-delà du miroir métallique (4) est compris entre 100 nm et 2,0 µm inclus.

9. Composant semiconducteur optoélectronique (1) selon l'une des revendications précédentes, avec lequel la couche d'encapsulation (5) est transparente et absorbe au maximum à 3,0 % un rayonnement traversant généré ou à recevoir par la couche active (30), la couche d'encapsulation (5) possédant du dioxyde de silicium et un dopage avec de l'aluminium étant effectué avec une concentration de substance dopante maximale de 1000 ppm.

10. Composant semiconducteur optoélectronique (1) selon l'une des revendications précédentes, la deuxième couche de miroir (6) débordant tout autour de la couche d'encapsulation (5) dans la direction latérale.

11. Composant semiconducteur optoélectronique (1) selon l'une des revendications précédentes, avec lequel le miroir métallique (4) est un miroir en argent, la deuxième couche de miroir (6) étant directement adjacente au miroir métallique (4) et la deuxième couche de miroir (6) étant électriquement conductrice et possédant l'un des matériaux suivants : Cr, un alliage de Cr, Ti, Au, Pt, Pd, Ni.

12. Composant semiconducteur optoélectronique (1) selon l'une des revendications précédentes, avec lequel un rapport entre une surface du miroir métallique (4) et une surface de la séquence de couches semiconductrices (3) est d'au moins 95 %.

13. Procédé de fabrication d'un composant semiconducteur optoélectronique anorganique selon l'une des revendications précédentes, comprenant les étapes suivantes :
- fourniture du support (2), de la séquence de couches semiconductrices (3) et du miroir métallique (4), le miroir métallique (4) se trouvant entre le support (2) et la séquence de couches semiconductrices (3) et étant débordé par celles-ci dans la direction latérale, et ensuite
- application de la couche d'encapsulation (5) dans la direction latérale immédiatement sur le miroir métallique (4), le support (2) étant différent d'un substrat de croissance de la séquence de couches semiconductrices (3) et la couche d'encapsulation (5) étant générée par le biais d'une précipitation de couches d'atomes.

14. Procédé selon la revendication précédente, une couche de protection (50) ayant une épaisseur comprise entre 100 nm et 500 nm inclus étant appliquée sur la couche d'encapsulation (5) par le biais d'une précipitation en phase gazeuse.

15. Procédé selon la revendication 13 ou selon la revendication précédente, la structuration de la séquence de couches semiconductrices (4) et du miroir métallique (4) étant réalisée par gravure et au moyen du même masque.
